# EUROPÄISCHE PATENTSCHRIFT

(11) **EP 1 205 026 B1**
(45) Veröffentlichungstag und Bekanntmachung des Hinweises auf die Patenterteilung: **19.10.2005**
(21) Anmeldenummer: 00956095.4
(22) Anmeldetag: 26.07.2000
(51) Int. Cl.: H03H 9/64

(54) **DUALMODE-OBERFLÄCHENWELLEN-FILTER MIT VERBESSERTER SYMMETRIE UND GGF. ERHÖHTER SPERRDÄMPFUNG**
DUAL-MODE SURFACE WAVE FILTER WITH ENHANCED SYMMETRY AND OPTIONALLY ENHANCED STOP-BAND ATTENUATION
FILTRE A ONDES DE SURFACE BIMODE A SYMETRIE AMELIOREE ET EVENTUELLEMENT AFFAIBLISSEMENT HORS BANDE AMELIORE

(30) Priorität: 16.08.1999 DE 19938748
(43) Veröffentlichungstag der Anmeldung: 15.05.2002
(73) Patentinhaber: EPCOS AG, 81669 München (DE)
(72) Erfinder: STRAUSS, Georg, D-81667 München (DE)
(74) Vertreter: Epping - Hermann - Fischer
(86) Internationale Anmeldenummer: PCT/DE2000/002448
(87) Internationale Veröffentlichungsnummer: WO 2001/013514

(56) Entgegenhaltungen:
- EP-A- 0 810 727
- WO-A-97/00556
- US-A- 4 254 387

## Beschreibung

Die vorliegende Erfindung bezieht sich auf ein vorzugsweise höchst selektives Hochfrequenz-Oberflächenwellenfilter desjenigen Typus, der als Dualmode-Oberflächenwellen-(OFW - /SAW-) Filter (DMS-Filter) bezeichnet wird. Es ist dafür-auch die Bezeichnung Longitudinalmodenresonatorfilter in Gebrauch. Bei solchen Oberflächenwellenfiltern handelt es sich um elektromechanische Filter, deren Strukturelemente wie Wandler und Resonatoren auf der Oberfläche eines piezoelektrischen Substrats positioniert sind.

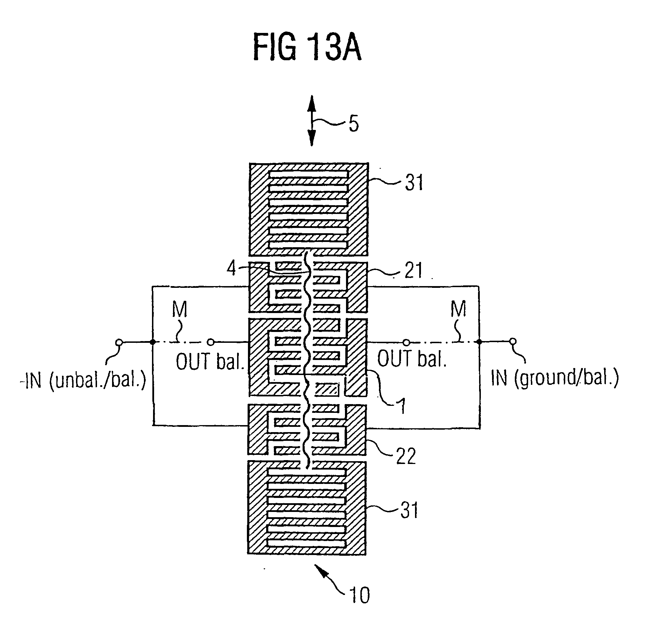

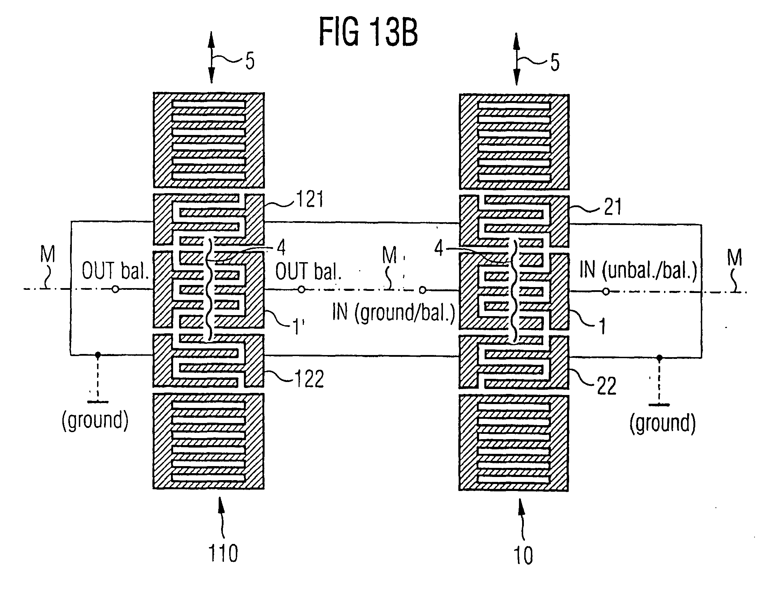

Bekannt sind solche Filter z.B. als Einspur-Filter. Für höhere Selektion werden auch Filter hergestellt und verwendet, in denen zwei solche Filterspuren zu einem Filter zusammengefaßt kaskadiert auf einem jeweiligen Substrat angeordnet sind. Die Figuren 13A und 13B zeigen ein bekanntes Einspur-DMS-Filter und ein bekanntes kaskadiertes Zweispur-Filter, dieses bestehend aus zwei miteinander verschalteten Einspur-DMS-Filtern.

Diese beiden Ausführungsformen haben, bezogen auf die jeweilige Oberflächenwellenspur, jeweils endständige Resonator-/Reflektorstrukturen und zwischen diesen für Signaleingang und für Signalausgang jeweils wenigstens eine Interdigitalstruktur als Wandler.

In dem Beispiel der Figur 13A für ein bekanntes Einspur-Filter 10 ist ein (erster) Wandler mit 1, zwei weitere (zweite) Wandler sind mit 21 und 22 und die Reflektorstrukturen sind mit 31 bezeichnet. Die beiden Wandler 21 und 22 sind hier, für die in dem Filter zu erzeugende und zu nutzende Oberflächenwelle 4 mit ihrer Ausrichtung 5 als Eingang des Filters elektrisch parallel geschaltet. Wie auch in der Figur angegeben, können diese Eingangswandler symmetrisch oder unsymmetrisch betrieben werden, mit entweder beidseitig symmetrischem Signaleingang (IN bal/IN ba1)oder einseitig gegen Masse (IN ground) unsymmetrischem (IN unbal) Eingang. Die Anschlüsse des in dieser Darstellung als Ausgang verwendeten Wandlers 1 sind symmetrische (OUT bal und OUT bal) Ausgänge. Es sei darauf hingewiesen, daß bei einem solchen Filter Eingang und Ausgang vertauscht sein können bzw. vertauscht benutzt werden können.

Die Figur 13B zeigt ein bekanntes kaskadiertes Filter, das zwei Spuren bzw. Einspur-Filter 10, 110 wie dargestellt miteinander verschaltet umfaßt. Bezugszeichen der Figur 13A sind auch hier verwendet. Bei diesem kaskadierten Filter ist beispielsweise der Wandler 1 als wahlweise unsymmetrischer / symmetrischer Eingang des Filters vorgesehen. Der Ausgang des Filters ist der Wandler 1'. Die übrigen Wandler 21, 121, 22, 122 sind hier, wie aus der Verschaltung ersichtlich, Koppelwandler, mit denen die beiden Spuren 10 und 110 elektrisch miteinander verkoppelt sind.

Es ist Praxis, daß der Wandler 1 der Einspur-Anordnung nach Figur 13A und die Wandler 1 und 1' der Figur 13B in Bezug auf die zur Ausrichtung 5 der Oberflächenwelle senkrechte Mittelebene M stets spiegelsymmetrisch ausgeführt sind und dementsprechend ungerade Anzahl ineinandergreifender Finger haben. In den beiden Figuren sind dies z.B. jeweils fünf interdigital angeordnete Finger der Wandler 1 und 1'.

Aus der Druckschrift US 4254387 ist eine Filteranordnung mit zwei akustischen Spuren bekannt, mit einem Eingangswandler in der ersten akustischen Spur und einem Ausgangswandler in der zweiten akustischen Spur, wobei die Spuren aneinander mittels Koppelwandler elektrisch gekoppelt und übereinander angeordnet sind. Der Eingangswandler kann punktsymmetrisch ausgebildet sein. Die Fingeranordnung der Koppelwändler kann bezogen auf die Mitte des Eingangswandlers punktsymmetrisch sein. Dabei ist jeder Koppelwandler einer Spur mit mehreren Koppelwandlern der anderen Spur verschaltet.

Aus der Druckschrift WO 97 00556 A sind ebenfalls transversal gekoppelte akustische Spuren bekannt. Ein Eingangswandler kann symmetrisch geschaltet sein. Die mit dem Eingangswandler akustisch gekoppelten Wandler dienen hier als Ausgangs wandler und nicht als Koppelwandler zur Ankopplung einer zweiten akustischen Spur.

Aus der Druckschrift EP 0810727 A ist eine zweispurige Filteranordnung mit drei Wandlern pro akustische Spur bekannt, wobei die mittleren Wandler zweier Spuren an ein symmetrisches Tor geschaltet sind. Die endständigen Wandler dienen hier als Koppelwandler. Sowohl die ersten als auch die zweiten Wandler weisen eine ungerade Fingeranzahl auf.

Aufgabe der vorliegenden Erfindung ist es, noch weiter verbesserte Symmetrie des Ausgangssignals eines einschlägigen Filters bei unsymmetrischem oder symmetrischem Eingangssignal zu erreichen.

Diese Aufgabe wird mit den Merkmalen des Patentanspruches 1 gelöst. Weitere Ausgestaltungen und Weiterbildungen der Erfindung gehen aus den Unteransprüchen hervor.

Weitere Erläuterungen zur Erfindung und ihren variierten Ausführungen gehen aus der Beschreibung zu den zur Erfindungsoffenbarung zugehörenden Figuren hervor.

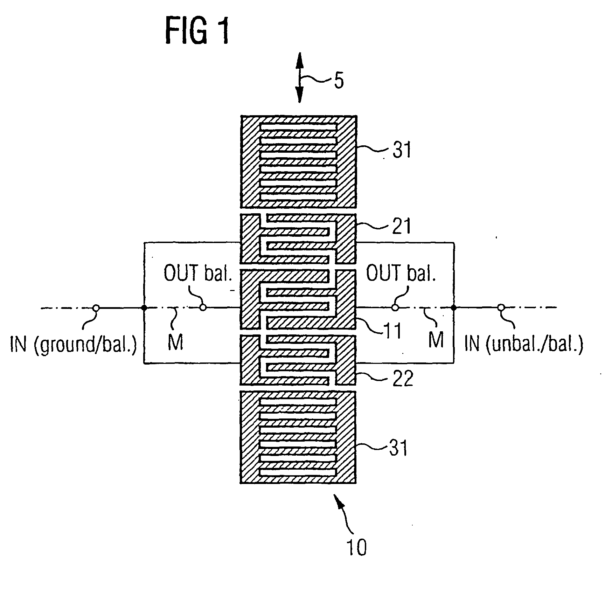

Die Figur 1 zeigt ein Dualmode-Einspur-Filter mit ähnlich wie bei Figur 13A auch hier zwei elektrisch parallel geschalteten, beispielsweise als Eingang vorgesehenen, (zweiten) Wandlern 21 und 22. Dieser Eingang kann als symmetrischer oder auch als unsymmetrischer Eingang betrieben werden. Mit 11 ist der hier erfindungsgemäß ausgeführte (erste) Wandler bezeichnet, der als symmetrisch zu betreibender Ausgangswandler geschaltet ist. Dieser Wandler 11 hat erfindungsgemäß mit hier beispielsweise vier Fingern eine gerade Anzahl Wandlerfinger. Er kann im Rahmen der Erfindung auch jegliche andere (praktisch relevante) gerade Anzahl interdigital ineinandergreifende Wandlerfinger haben und unterscheidet sich damit prinzipiell vom Stand der Technik, nämlich von dem Wandler 1 mit ungerader Anzahl seiner Finger.

Das Filter der Figur 1 liefert sowohl bei symmetrischem als auch unsymmetrischem Eingangssignal ein symmetrisches Ausgangssignal, und zwar aufgabengemäß mit besonders hoher Symmetrie.

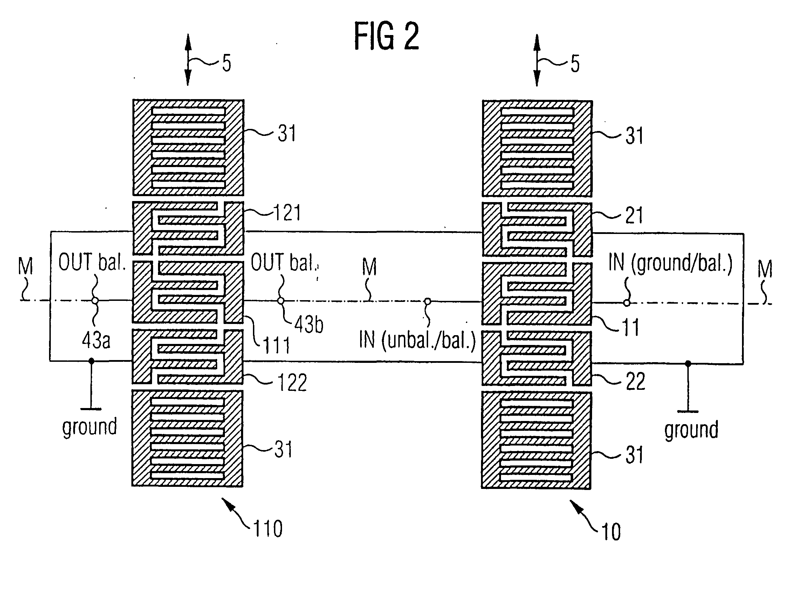

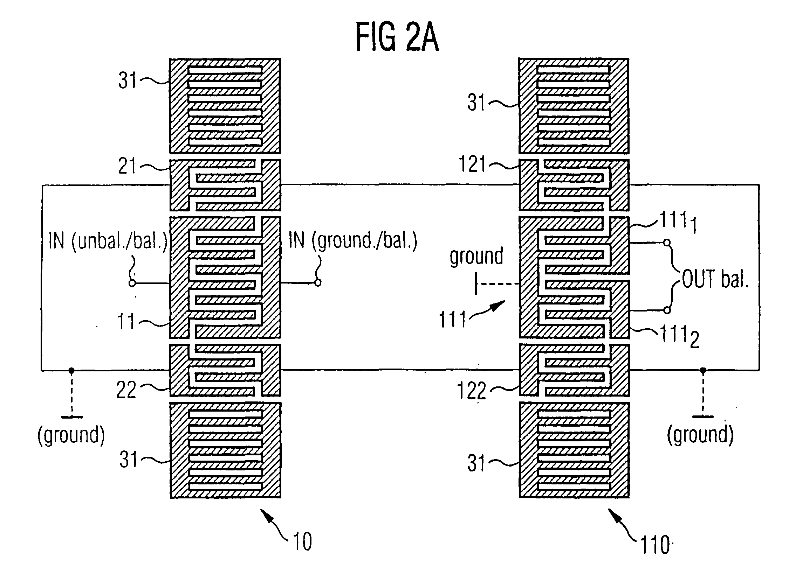

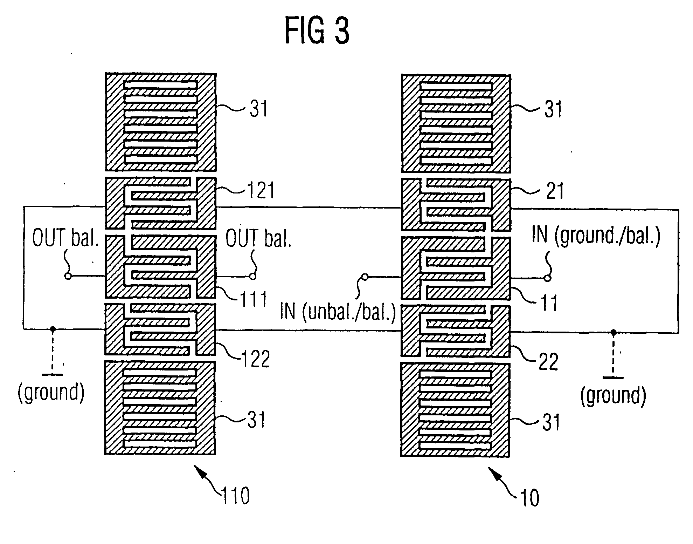

Die Figuren 2 und 3 zeigen je ein erfindungsgemäßes Zweispur-Filter. Erfindungswesentlich unterscheiden sich diese Filter darin vom Stand der Technik (Figur 13B), daß die Wandler 11 und 111 wieder ausschließlich geradzahlige Anzahl Elektrodenfinger haben. Bei der Erfindung sind diese ersten Wandler in Bezug auf die oben definierte Mittelebene M (senkrecht zur Wellenausbreitungsrichtung 5) nicht spiegelsymmetrisch und dennoch zeigt das Filter mit dieser Maßnahme der Erfindung verbesserte Symmetrie. Wie schon zum Stand der Technik beschrieben (Figur 13B) bildet hier der Wandler 11 den z.B. fakultativ unsymmetrischen oder symmetrischen Eingang und der Wandler 111 den symmetrischen Ausgang mit den Anschlüssen 43a, 43b des Filters. Die jeweils beiden (zweiten) Wandler 21 und 22 sowie 121 und 122 sind hier als Koppelwandler miteinander wie angegeben verschaltet. Das Filter nach Figur 2 ist ein solches mit Gleichtakt-Kopplung zwischen den beiden Spuren 10 und 110. Das Filter nach Figur 3 ist so aufgebaut, daß die Kopplung zwischen den beiden Spuren 10 und 110 im Gegentakt erfolgt. Ausgeführt wird dies dadurch, daß die Koppelwandler 22 und 122 vergleichsweise zur Figur 2 umgekehrt polaren Aufbau haben. Zur Figur 3 ist noch zu erwähnen, daß bei diesem Filter der Masseanschluß wie angedeutet fakultativ möglich ist.

Die Figur 2A zeigt eine Variation zur Ausführung nach Figur 2. Die Variation besteht darin, daß der (erste) als Ausgang bezeichnete Wandler 111 aus zwei elektrisch in Reihe geschalteten Wandleranteilen 111₁ und 111₂ besteht, die jeder geradzahlige (je vier Finger dargestellt) oder auch eine ungeradzahlige Fingeranzahl haben. Bei diesem Filter liegt eine 1:4 Impedanztransformation vom Eingang (IN) zum Ausgang (OUT) vor.

Der Vorteil der mehrspurigen erfindungsgemäßen Ausführungen eines solchen Dualmode-Filters nach den Figuren 2, 2A und 3 hat zusätzlich zu dem Vorteil, den bereits das erfindungsgemäße Filter nach Figur 1 bringt, eine noch weiter verbesserte Symmetrie.

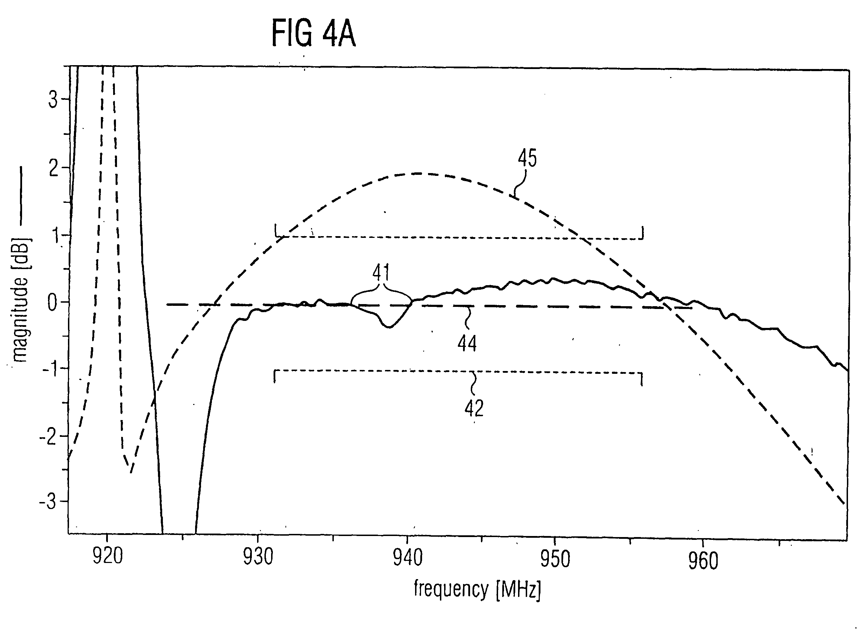

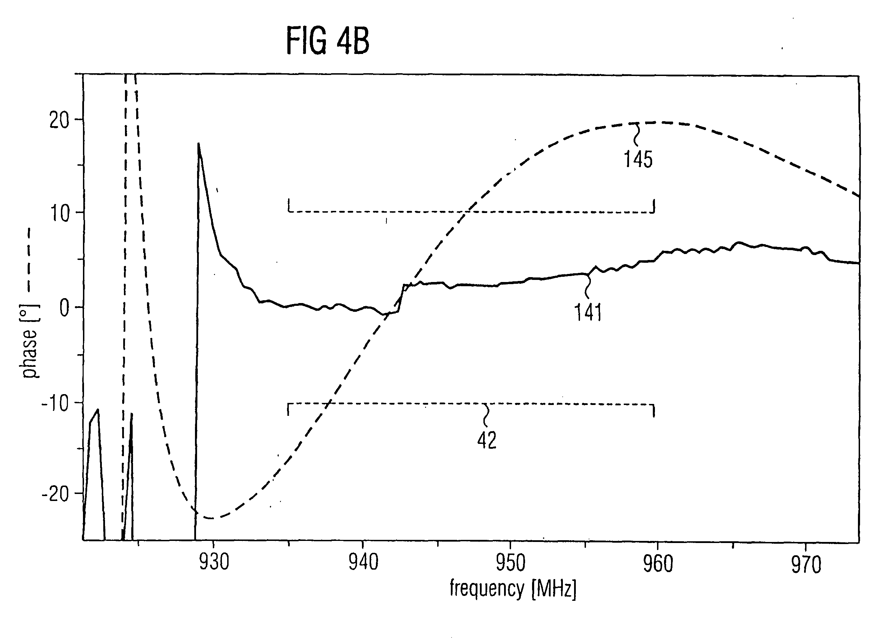

Die Figuren 4A und 4B zeigen die mit einem Filter mit der Ausführung nach Figur 2 erzielte Verbesserung, und zwar gegenüber einem Filter nach Figur 13B. Mit 41 ist die die erzielte Symmetrie repräsentierende Meßkurve bezeichnet, aufgetragen über der Frequenz für das mit 42 angegebene, vorgegebene Frequenzband. Die Meßkurve 41 gibt das Signalverhältnis wieder. Es ist dies das Verhältnis der bei zwei Zweitor-Messungen an den Anschlüssen 43a, 43b (gegen Masse) zu messenden Einzelsignale. Dabei ist der jeweils nicht mit dem Meßgerät verbundene Anschluß mit jeweils dem Bezugs-Wellenwiderstand des Meßsystems abgeschlossen. Wie aus der Figur 4A ersichtlich, liegt diese Kurve 43, d.h. der Betrag des Amplitudenverhältnisses nahe 0 dB (in der Figur mit 44 bezeichnet). Die Figur 4B zeigt, und zwar wieder für das Frequenzband 42, mit der Kurve 141, den Verlauf der Phasendifferenz Δϕ für das symmetrische Ausgangssignal. Wie aus Figur 4B ersichtlich, liegt die Phasendifferenz über das gesamte Frequenzband hinweg nahe dem Wert 180° (dargestellt ist Δϕ - 180°).

In den Figuren 4A und 4B sind noch gestrichelt die Kurven 45 für Symmetrie und 145 für Phasendifferenz eingetragen, die an einem Filter des Standes der Technik gemäß Figur 13B ermittelt worden sind. Der mit der Erfindung erzielte Fortschritt ist somit aus Figur 4 offensichtlich.

Die Figuren 5 und 6 zeigen jeweils eine Weiterbildung eines Filters nach Figur 1 bzw. nach Figur 3.-Das Filter nach Figur 6 ist mit Umpolung von Koppelwandlern auch eine Weiterbildung des Filters nach Figur 2.

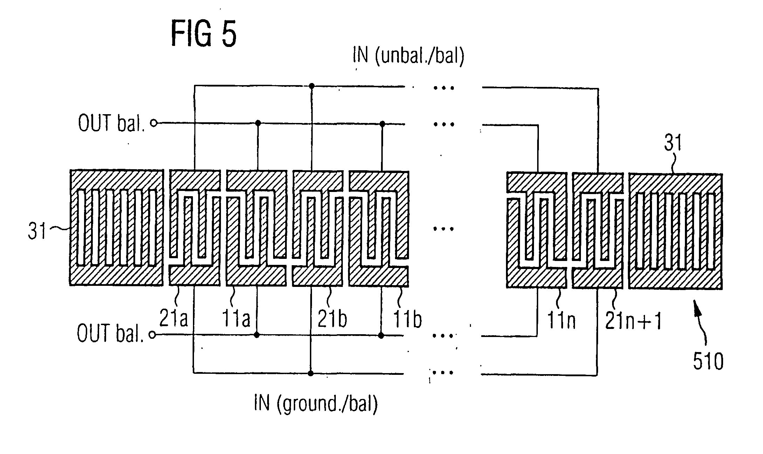

Die Figur 5 zeigt ein hier mehrfach akusto-mechanisch verkoppeltes Einspurfilter mit der Spur 510 mit den im Filter in dieser Spur vorhandenen Wandlern, die alle jeweils geradzahlige Anzahl Wandlerfinger haben. Damit ist die erfindungsgemäße Lehre auch beim Filter der Figur 5 erfüllt. Im Filter der Figur 5 sind eine Mehrzahl (n) parallel geschalteter (erster) Wandler 11a, 11b, ... 11n vorgesehen, die dem ersten Wandler 11 der Figur 1 entsprechen. Auch in Figur 5 sind diese Wandler z.B. als symmetrischer Ausgang geschaltet. Mit 21a, 21b, ..., 21ₙ₊₁ sind (n+1) (zweite) Wandler mit ebenfalls geradzahliger Fingeranzahl vorgesehen, die den Wandlern 21 bzw. 22 der Figur 1 entsprechen und auch in Figur 5 als Eingang des Filters miteinander parallel geschaltet sind. Mit 31 sind die zugehörigen Reflektorstrukturen bezeichnet. Mit einer solchen Ausführung nach Figur 5 läßt sich insbesondere größere Bandbreite erreichen.

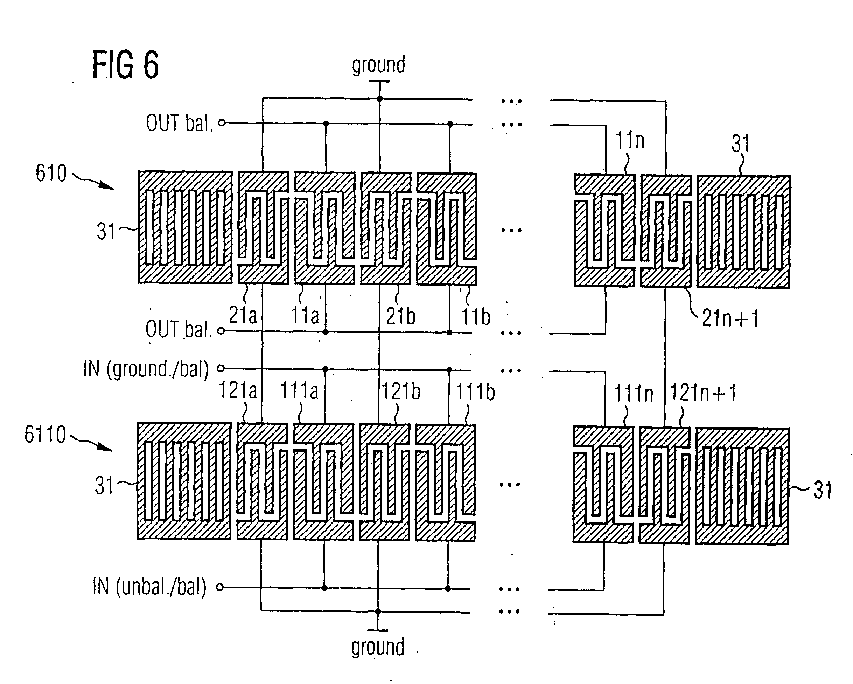

In analoger Weise ist das Filter der Figur 6 als der Figur 5 entsprechende Weiterbildung des Zweispur-Filters der Figuren 2 bzw. 3 mit den Spuren 610 und 6110 ausgeführt. Die Spur 610 entspricht im Aufbau der Spur 510 des Filters der Figur 5 und der Spur 10 des Filters der Figur 2. Als Weiterbildung enthält die Spur 610 wiederum die Wandler 11a, 11b, ... 12n einerseits und die Wandler 21a, 21b, ..., 21ₙ₊₁ andererseits. So wie diese Wandler jeweils miteinander parallel geschaltet sind, dienen diese auch in der Spur 610 als Eingangswandler und als Ausgangswandler gemäß der aus der Figur 6 zu entnehmenden Verschaltung. Das Entsprechende gilt auch für die zweite Spur 6110 des Filters der Figur 6 mit den Wandlern 111a, 111b, ..., 111n; 121a, 121b, ..., 121ₙ₊₁ und jeweils weiteren Wandlern 11, 111 des Zweispurfilters der Figur 6 mit dieser Weiterbildung der Erfindung bzw. Weiterbildung eines Filters nach Figur 2 bzw. nach Figur 3. Mit diesen beschriebenen Maßnahmen läßt sich (auch) die Sperrdämpfung außerhalb des vorgegebenen Bandes verbessern.

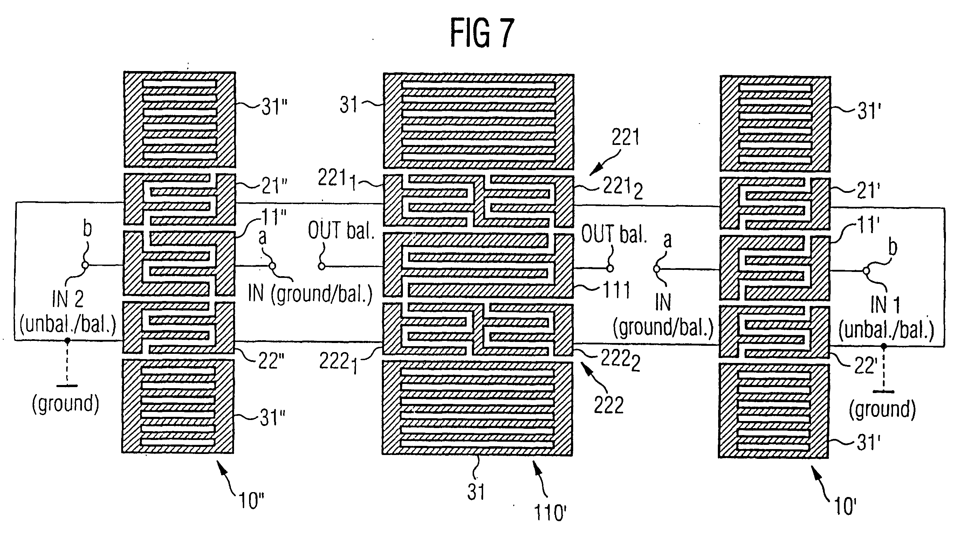

Die Figur 7 zeigt eine weitere Weiterbildung der Erfindung, mit der (zusätzlich) eine höhere Sperrselektivität des Dualmode-Filters erzielt werden kann.

Das Prinzip des Filters nach Figur 7 umfaßt weiterhin die stets geradzahlige Fingeranzahl der (ersten) Wandler 11', 111 und hier zusätzlich des Wandlers 11".

Das neue Prinzip des Filters nach Figur 7 ist, daß, verglichen mit dem Filter nach Figur 2, die dortige Spur 10 dieses Filters hier aufgeteilt ist in zwei Spuren 10' und 10'', mit je halb so großer Apertur wie die (mittlere) Spur 110'. Beim Filter der Figur 7 ist der Anschluß a des Wandlers 11' mit dem Anschluß a des Wandlers 11'' und der Anschluß b des Wandlers 11' mit dem Anschluß b des Wandlers 11'' verbunden. Die beiden (ersten) Wandler 11' und 11'' sind also elektrisch parallel geschaltet. Die Verschaltung der (zweiten) Wandler (in Figur 2 und Figur 7 der Koppelwandler) der beiden Spuren 10' und 10'' miteinander, nämlich der Wandler 21' und 22' einerseits und 21'' und 22'' andererseits mit dem Wandler 221 bzw. 222 der Spur 110' geht aus der Figur 7 hervor. Es liegt hier eine Gleichtakt-Schaltung vor, wie in Figur 2. Die Reflektorstrukturen 31', 31'' sind durch die Teilung in die Spuren 10' und 10'' aus den Reflektorstrukturen 31 der Spur 10 hervorgegangen. Die Reflektoren der Spur 110' sind mit 31 bezeichnet.

Die (zweiten) Koppelwandler 221 und 222 der Spur 110' sind eine weitere Besonderheit dieser weitergebildeten Ausführungsform der Erfindung. Sie sind, wie aus der Figur ersichtlich, in Anteile aufgeteilt. Der Koppelwandler 221 besteht aus zwei, wie aus der Figur ersichtlichen Anteilen 221₁ und 221₂, nämlich zwei Interdigitalwandlern, die durch den konstruktiven Aufbau eine Einheit bilden. Dabei ist die Phase des akustischen Wellenfeldes innerhalb des Wandlers 221 bzw. 222 senkrecht zur Wellenausbreitungsrichtung jeweils konstant. Der Impedanzunterschied zwischen den Anschlüssen beträgt das Vierfache bzw. ein Viertel. Das Gleiche gilt für den Koppelwandler 222 und seine Anteile 222₁ und 222₂.

Die Funktionsweise des Filters nach Figur 7 ist folgende: Durch die Aufspaltung sind die beiden Eingangs-Filterspuren 10' und 10'' gebildet, die zudem in die Filterstruktur symmetrisch eingefügt sind. Die Impedanz eines jeden darin enthaltenen ersten und zweiten Wandlers 11', 21', 22' und 11'', 21'', 22'' ist wegen der halbierten Apertur doppelt so groß wie die eines Wandlers 11, 21 und 22. Da die Wandler 11' und 11'' parallel geschaltet sind, ist die gleich hohe Eingangsimpedanz wie beim Filter der Figur 2 und wie in der Spur 110 vorhanden. Die Wandler 21' und 21'' sowie 22' und 22'' sind jeweils in der dargestellten Schaltung in Reihe geschaltet. Die Impedanz des einzelnen Wandlers ist damit viermal so hoch, verglichen mit den Wandlern 21, 22 der Figur 2. Da jedoch der gesplittete Wandler 221 (und ebenso der Wandler 222) aus hintereinander geschalteten Wandleranteilen besteht, ist dessen (221, 222) Impedanz ebenfalls vergleichsweise viermal so hoch.

Diese Weiterbildung der Erfindung gemäß Figur 7 hat in dieser Ausgestaltung eingangsseitig und ausgangsseitig gleich große Impedanz, wie dies für die Filter der Figuren 1 bis 3 der Fall ist und wie dies in der Regel in der Praxis verlangt wird.

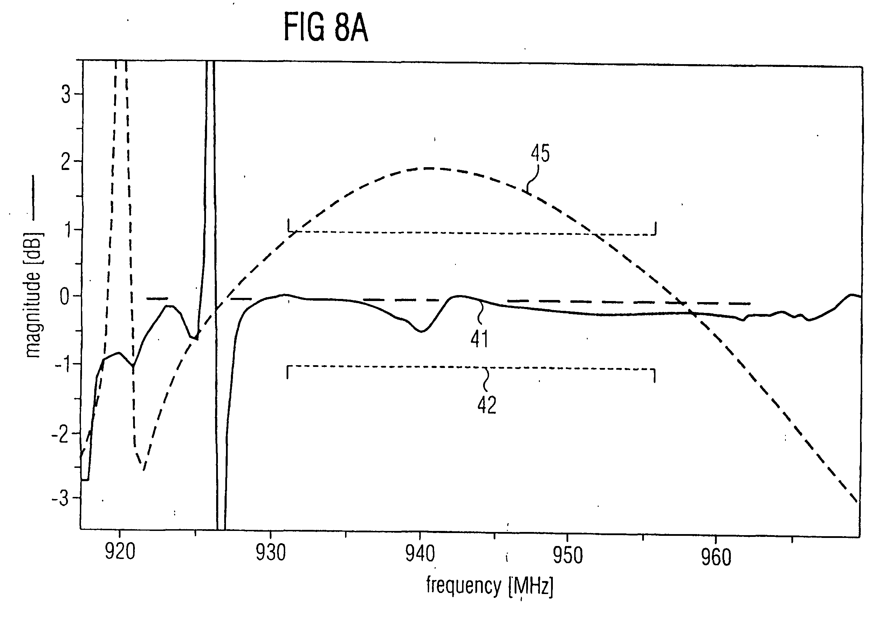

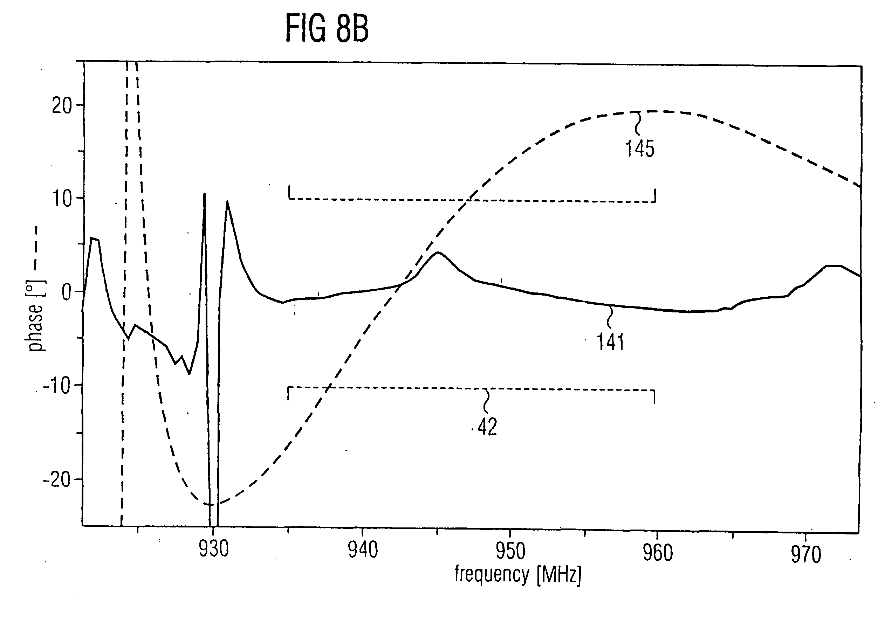

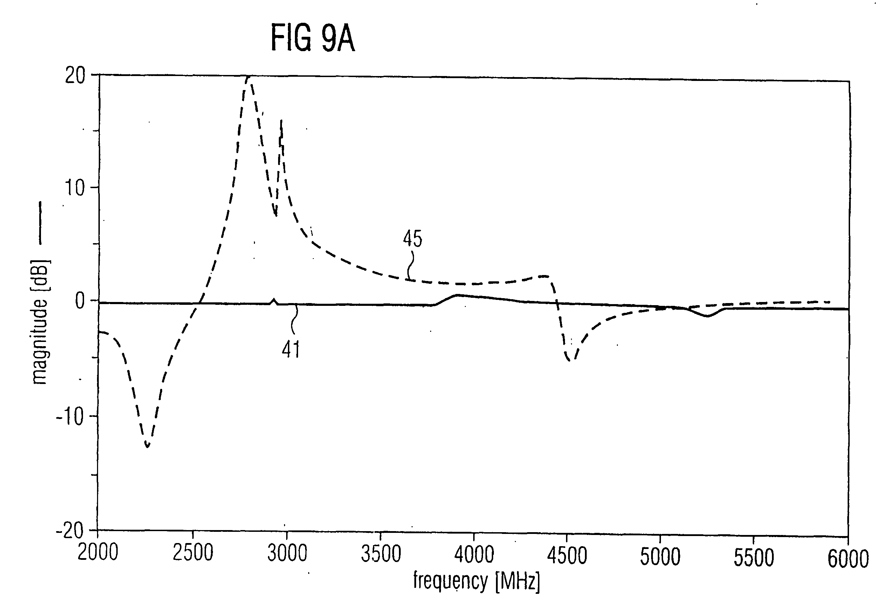

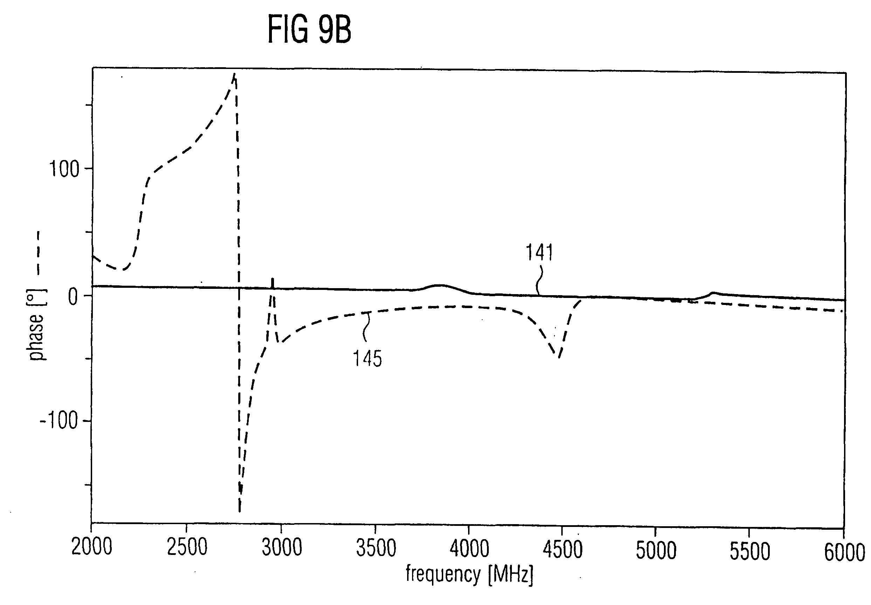

Das Filter der Figur 7 hat schon aufgrund des konstruktiven Aufbaus hohe Symmetrieeigenschaft. Dies ist aus den Meßkurven 41 für Symmetrie und 141 für den Phasenverlauf gemäß der Figuren 8A und 8B zu ersehen. Zur weiteren Erläuterung dieser Figuren sei auf die Beschreibung zu den Figuren 4A und 4B verwiesen. Das Filter der Figur 7 hat aufgrund seines hinsichtlich der Symmetrie noch weiter verbesserten konstruktiven Aufbaues auf der Oberfläche des Substrats eines solchen Filters besonders hohe Signal-Symmetrie und dazu noch, wie schon erwähnt, verbesserte Sperrdämpfung. Die Figuren 9A und 9B zeigen die Kurve 41 der Symmetrie des Signals des Filters und den zugehörigen Phasenverlauf 141 im Bereich außerhalb des vorgegebenen Filterbandes 42, hier im Frequenzbereich von 2 bis 6 GHz. Die gestrichelten Kurven 45 und 145 in diesen Figuren zeigen die Vergleichswerte eines Filters des Standes der Technik.

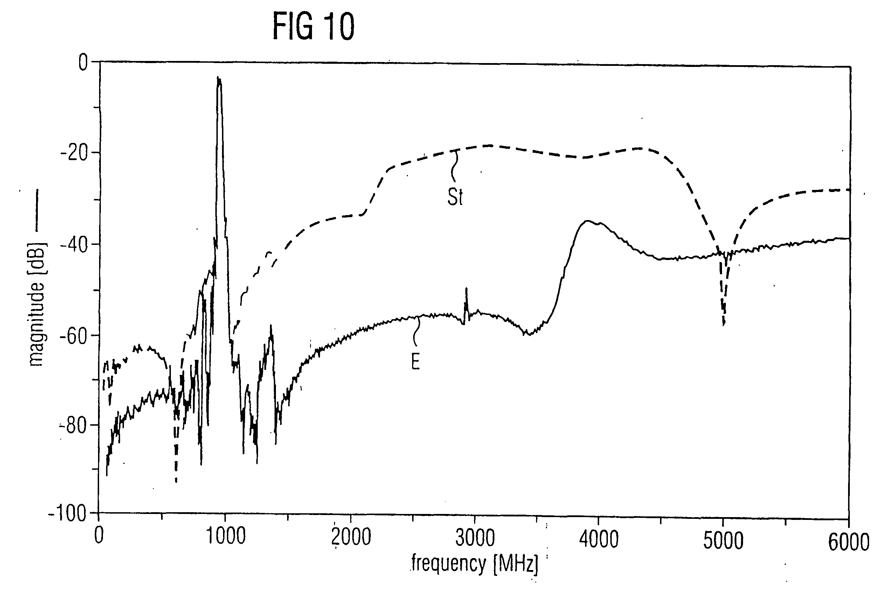

Die Figur 10 zeigt das Übertragungsverhalten eines Filters nach Figur 7 mit zwei elektrisch parallelgeschalteten ersten Spuren 10', 10'' und der dritten Spur 110'. Dieses Filter nach Figur 7 hat Balunfunktionalität. Die Kurve E zeigt das Übertragungsverhalten eines Filters nach Figur 7 und die Kurve St dasjenige eines Zweispur-Filters des Standes der Technik gemäß Figur 13B.

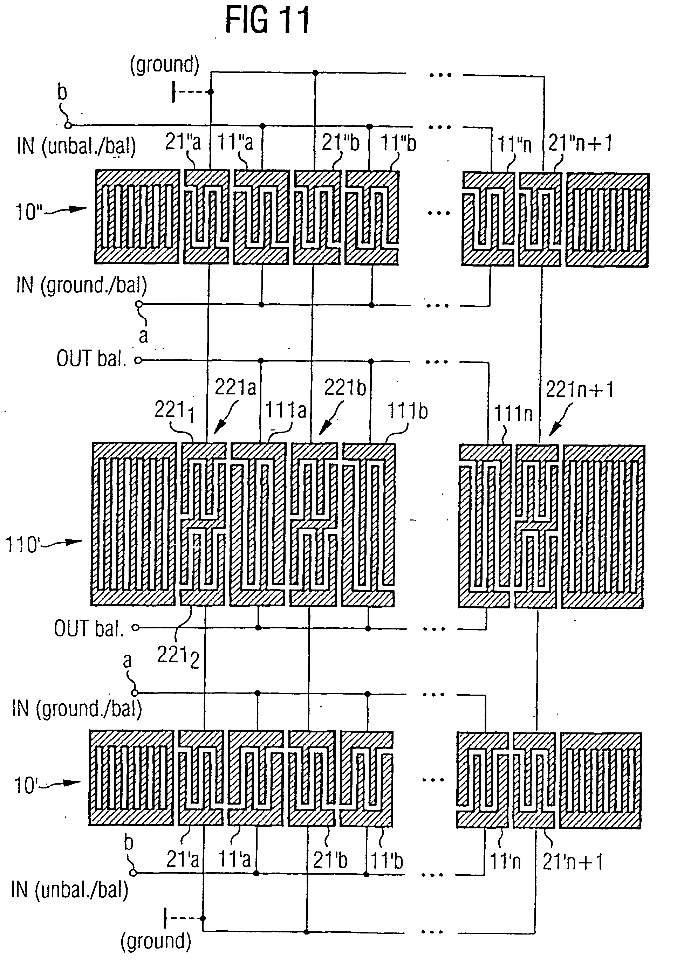

Die Figur 11 zeigt eine Weiterbildung der Ausführung der Erfindung nach Figur 7 , die im wesentlichen analog der Weiterbildung nach Figur 6 (und damit auch nach Figur 5) der Ausführungen gemäß den Figuren 1 bis 3 ist. Dort gegebene Erläuterungen gelten sinngemäß auch für die Ausführung nach Figur 11. Entsprechendes gilt für die auch in der Figur 11 benutzten Bezugszeichen der bisherigen Figuren. Mit 11'a, 11'b, ..., sind die (ersten) Wandler mit wieder erfindungsgemäß geradzahliger Fingeranzahl und punktsymmetrischem Aufbau der einen Spur 10' bezeichnet. Entsprechendes gilt für die (ersten) Wandler 11''a, 11''b, ..., der anderen Spur 10''. Auch hier sind diese Spuren 10' und 10'' zu vergleichen mit der einen Spur 10 eines Zweispur-Filters. Die Wandler 111a, 111b, ..., der in der Figur 11 mittleren, dritten Spur sind ebenfalls solche ersten Wandler. Diese ersten Wandler der Spuren 10', 10'' und 110' sind innerhalb der jeweiligen Spur elektrisch miteinander parallelgeschaltet. Dabei sind diese Parallelschaltungen der Spuren 10' und 10'' wiederum elektrisch miteinander parallelgeschaltet, nämlich durch verbindung der jeweils mit a und b bezeichneten Anschlüsse. In der Figur 11 ist diese Parallelschaltung, d.h. sind die Anschlüsse a und b als Eingang (IN) des Filters deklariert. In jeder der Spuren 10' und 10'' sind diese (ersten) Wandler n-fach vorgesehen. In dazu (n+1)-facher Anzahl sind die (zweiten), als Koppelwandler dienenden Wandler 21'a, 21'b,..., 21'ₙ₊₁ und 21''a, 21''b, ..., 21''ₙ₊₁ der Spuren 10' und 10'' und 221a, 221b, ..., 221ₙ₊₁ der Spur 110 vorgesehen. Auch diese (zweiten) Wandler sind in der jeweiligen Spur elektrisch miteinander parallelgeschaltet, wie dies der Figur zu entnehmen ist. Außerdem sind diese (zweiten) Wandler, wie in der Figur 11 gezeigt, elektrisch zwischen den einzelnen Spuren miteinander verbunden, nämlich in ihrer Funktion als Koppelwandler des dargestellten dreispurigen Filters, das aufgrund der elektrischen Verschaltung ein solches des Typs eines Zweispur-Filters ist. Mit 31', 31'' und 31 sind die üblichen Reflektoren der jeweiligen Spur bezeichnet.

Ein solches mehrspuriges Filter nach Figur 11 mit der erhöhten auch konstruktiv ausgeführten Symmetrie eines Filters nach Figur 7 werden die Vorteile erzielt, die einerseits mit einem Filter nach z.B. Figur 6 und andererseits einem Filter nach Figur 7 gegenüber dem Stand der Technik zu erreichen sind.

Das Filter der Figur 11 zeigt außerdem wie in Figur 7 zweite Wandler 221a, ... der mittleren, dritten Spur 110', die aus wie schon oben zur Figur 7 beschriebenen Anteilen 221₁ und 221₂ bestehen, die elektrisch hintereinandergeschaltet und wellenakustisch parallelgeschaltet wirksam sind.

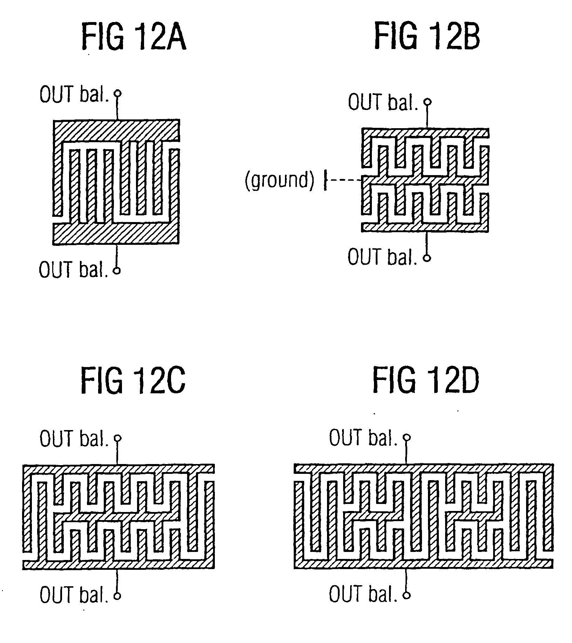

Die Figur 12 zeigt einige Beispiele für Ausführungen von Wandlern, wie sie für erste und zweite Wandler der Erfindung bzw. den dargestellten Ausführungstypen verwendet werden können, nämlich als gewichtete wandler (Figur 12A) und/oder als Wandler (Figuren 12B bis 12D) mit Impedanztransformation. Wieder hat ein solcher Wandler der Figur 12A jeweils insgesamt geradzahlige Fingeranzahl. Dasselbe gilt auch für die Wandler der Figuren 12B, 12C und 12D. Der Wandler der Figur 12B hat ein Impedanz-Transformationsverhältnis von 1:4 (bzw. 4:1). Die Wandler der Figuren 12C und 12D sind so ausgebildet, daß sie ein von einer ganzen Zahl (wählbar) abweichendes Verhältnis der Impedanztransformation bilden. Erfindungswesentlich gemeinsam ist auch diesen Wandlern der Figuren 12A bis 12D, daß sie hinsichtlich ihrer Symmetrie punktsymmetrisch ausgeführt sind.

## Patentansprüche

1. Dualmode-Oberflächenwellen-Filter, enthaltend:
- einen Signaleingang (IN) und einen Signalausgang (OUT) als elektrische Tore, wobei zumindest eines der elektrischen Tore symmetrisch ist;
- eine erste (6110, 10', 10'') und eine zweite (610, 110') Filterspur, wobei jede Filterspur zumindest einen ersten Wandler (111a, 111b, 11a, 11b) und mehrere zweite Wandler (121a, 121b, 21a, 21b) aufweist, wobei jeder Wandler eine gerade Anzahl von Wandlerfingern, die interdigital angeordnet sind, aufweist;
- Reflektorstrukturen (31);
wobei jeder zweite Wandler (121a) der ersten Filterspur an einen einzigen zweiten Wandler (21a) der zweiten Filterspur elektrisch gekoppelt ist;
wobei der zumindest eine erste Wandler (111a, 111b) der ersten Filterspur an den Signaleingang (IN) angeschlossen ist;
wobei der zumindest eine erste Wandler (11a, 11b) der zweiten Filterspur an den Signalausgang (OUT) angeschlossen ist;
wobei in jeder Filterspur die Fingeranordnung des ersten Wandlers punktsymmetrisch bezüglich seines Mittelpunkts ist;
wobei in jeder Filterspur der zumindest eine erste Wandler zwischen zwei zweiten Wandlern angeordnet ist,
a) deren Fingeranordnung bezüglich des Mittelpunkts des entsprechenden ersten Wandlers zueinander punktsymmetrisch ist, oder
b) deren Fingeranordnung bezüglich der Achse, welche durch den Mittelpunkt des entsprechenden ersten Wandlers orthogonal zur Wellenausbreitungsrichtung verläuft, zueinander spiegelsymmetrisch ist.

2. Filter nach Anspruch 1,
mit mehr als nur einer ersten Filterspur.

3. Filter nach Anspruch 1 oder 2, enthaltend:
in jeder ersten (6110) und zweiten (610) Filterspur eine Anzahl n der ersten Wandler (11a, 11b, 111a, 111b), die miteinander parallel geschaltet sind, wobei n eine ganze Zahl > 1 ist;
eine Anzahl (n + 1) der zweiten Wandler (21a, 21b, 121a, 121b) ;
wobei die Anzahl n der ersten Wandler (111a, 111b) der ersten Filterspur an den Signaleingang (IN) angeschlossen ist;
wobei die Anzahl n der ersten Wandler (11a, 11b) der zweiten Filterspur an den Signalausgang (OUT) angeschlossen ist.

4. Filter nach Anspruch 3,
mit zwei ersten Filterspuren (10', 10''), deren erste Wandler (11', 11'') bezüglich des Signaleingangs (IN/IN1, IN/IN2) parallel miteinander geschaltet sind;
wobei der jeweilige zweite Wandler (221, 222) der zweiten Filterspur (110') an jeweils einen zweiten Wandler (21', 21''; 22', 22'') der beiden ersten Filterspuren elektrisch gekoppelt ist und
wobei die zweite Filterspur (110') zwischen den beiden ersten Filterspuren (10', 10'') angeordnet ist.

5. Filter nach Anspruch 1 bis 4,
bei dem der zumindest eine erste Wandler und/oder die zweiten Wandler (221, 222) der entsprechenden Filterspur eine strukturelle Einheit aus je zwei Wandleranteilen (221₁, 221₂, 222₁, 222₂) aufweisen, welche elektrisch hintereinander geschaltet und akustisch parallel zueinander angeordnet sind.

6. Filter nach Anspruch 1 bis 5,
bei dem in zumindest einer Filterspur, ausgewählt aus der ersten und der zweiten Filterspur, der zumindest eine erste Wandler und die zweiten Wandler gewichtet sind.

7. Filter nach Anspruch 1 bis 6,
bei dem die erste und zweite Filterspur eine Gleichtaktkopplung aufweisen.

8. Filter nach Anspruch 1 bis 7,
bei dem der zumindest eine erste Wandler und/oder die zweiten Wandler der entsprechenden Filterspur eine Impedanztransformation aufweisen, wobei der entsprechende Wandler zumindest teilweise in Wandleranteile aufgeteilt ist, welche elektrisch hintereinander geschaltet und akustisch parallel zueinander angeordnet sind.

## Claims

1. Dual-mode surface acoustic wave filter, containing:
- a signal input (IN) and a signal output (OUT) as electrical ports, with at least one of the electrical ports being balanced;
- a first (6110, 10', 10'') and a second (610, 110') filter track, with each filter track having at least one first transducer (111a, 111b, 11a, 11b) and a plurality of second transducers (121a, 121b, 21a, 21b), with each transducer having an even number of transducer fingers, which are arranged interdigitally;
- reflector structures (31);
with every alternate transducer (121a) in the first filter track being electrically coupled to a single second transducer (21a) in the second filter track;
with the at least one first transducer (111a, 111b) in the first filter track being connected to the signal input (IN);
with the at least one first transducer (11a, 11b) in the second filter track being connected to the signal output (OUT);
with the finger arrangement of the first transducer having point symmetry with respect to its centre point in each filter track;
with the at least one first transducer being arranged between two second transducers in each filter track,
a) whose filter arrangement has mutual point symmetry with respect to the centre point of the corresponding first transducer, or
b) whose finger arrangement has mutual mirror-image symmetry with respect to the axis which runs through the centre point of the corresponding first transducer at right angles to the wave propagation direction.

2. Filter according to Claim 1,
having more than just one first filter track.

3. Filter according to Claim 1 or 2, containing:
a number n of first transducers (11a, 11b 111a, 111b) in each first filter track (611) and second filter track (610), which are connected in parallel with one another, with n being an integer greater than 1;
a number (n + 1) of second transducers (21a, 21b, 121a, 121b);
with the number n of first transducers (111a, 111b) in the first filter track being connected to the signal input (IN);
with the number n of first transducers (11a, 11b) in the second filter track being connected to the signal output (OUT).

4. Filter according to Claim 3,
having two first filter tracks (10', 10''), whose first transducers (11', 11'') are connected in parallel with one another with respect to the signal input (IN/IN1, IN/IN2);
with the respective second transducer (221, 222) in the second filter track (110') being electrically coupled to in each case one second transducer (21', 21''; 22', 22'') in the two first filter tracks, and
with the second filter track (11') being arranged between the two first filter tracks (10', 10'').

5. Filter according to Claims 1 to 4,
in which the at least one first transducer and/or the second transducers (221, 222) in the corresponding filter track have/has a structural unit composed of in each case two transducer components (221₁, 221₂, 222₁, 222₂) which are electrically connected in series and are acoustically arranged in parallel with one another.

6. Filter according to Claims 1 to 5,
in which, in at least one filter track, selected from the first and the second filter tracks, the at least one first transducer and the second transducers are weighted.

7. Filter according to Claims 1 to 6,
in which the first and second filter tracks have common-mode coupling.

8. Filter according to Claims 1 to 7,
in which the at least one first transducer and/or the second transducers in the corresponding filter track has or have an impedance transformation, with the corresponding transducer being at least partially subdivided into transducer components which are electrically connected in series and are acoustically arranged in parallel with one another.

## Revendications

1. Filtre à ondes de surface bimode, comprenant :
- une entrée de signal (IN) et une sortie de signal (OUT) en tant que portes électriques, au moins l'une des portes électriques étant symétrique ;
- une première piste de filtrage (6110, 10', 10'') et une deuxième piste de filtrage (610, 110'), chaque piste de filtrage comportant au moins un premier convertisseur (111a, 111b, 11a, 11b) et plusieurs deuxièmes convertisseurs (121a, 121b, 21a, 21b), chaque convertisseur comportant un nombre pair de doigts convertisseurs selon une disposition interdigitée;
- des structures de réflexion (31) ;
chaque deuxième convertisseur (121a) de la première piste de filtrage étant connecté électriquement à un seul deuxième convertisseur (21a) de la deuxième piste de filtrage ;
le ou les premiers convertisseurs (111a, 111b) de la première piste de filtrage étant raccordés à l'entrée de signal (IN) ;
le ou les premiers convertisseurs (11a, 11b) de la deuxième piste de filtrage étant raccordés à la sortie de signal (OUT) ;
dans chaque piste de filtrage, la disposition des doigts du premier convertisseur présentant une symétrie ponctuelle par rapport à son centre ;
dans chaque piste de filtrage, le ou les premiers convertisseurs étant disposés entre deux deuxièmes convertisseurs,
a) dont la disposition des doigts présente une symétrie ponctuelle par rapport au centre du premier convertisseur respectif, ou
b) dont la disposition des doigts présente une symétrie en miroir par rapport à l'axe qui passe par le centre du premier convertisseur correspondant et qui est perpendiculaire à la direction de propagation des ondes.

2. Filtre selon la revendication 1, avec plus d'une première piste de filtrage.

3. Filtre selon la revendication 1 ou 2, contenant :
dans chaque première piste de filtrage (6110) et dans chaque deuxième piste de filtrage (610), un nombre n des premiers convertisseurs (11a, 11b, 111a, 111b) qui sont branchés en parallèle entre eux, n étant un nombre entier > 1 ;
un nombre (n + 1) des deuxièmes convertisseurs (21a, 21b, 121a, 121b) ;
les n premiers convertisseurs (111a, 111b) de la première piste de filtrage étant raccordés à l'entrée de signal (IN) ;
les n premiers convertisseurs (11a, 11b) de la deuxième piste de filtrage étant raccordés à la sortie de signal (OUT).

4. Filtre selon la revendication 3,
avec deux premières pistes de filtrage (10', 10'') dont les premiers convertisseurs (11', 11'') sont branchés en parallèle entre eux par rapport à l'entrée de signal (IN / IN1, IN / IN2) ;
le deuxième convertisseur respectif (221, 222) de la deuxième piste de filtrage (110') étant connecté électriquement à chaque fois à un deuxième convertisseur (21', 21'' ; 22', 22'') des deux premières pistes de filtrage ; et
la deuxième piste de filtrage (110') étant disposée entre les deux premières pistes de filtrage (10', 10'').

5. Filtre selon l'une des revendications 1 à 4,
dans lequel le ou les premiers convertisseurs et/ou les deuxièmes convertisseurs (221, 222) de la piste de filtrage correspondante comportent une unité structurelle composée à chaque fois de deux composantes de convertisseur (221₁, 221₂, 222₁, 222₂) qui sont branchées électriquement l'une derrière l'autre et qui sont disposées acoustiquement en parallèle l'une de l'autre.

6. Filtre selon l'une des revendications 1 à 5,
dans lequel, dans au moins une piste de filtrage, sélectionnée parmi la première et la deuxième piste de filtrage, le ou les premiers convertisseurs et les deuxièmes convertisseurs sont pondérés.

7. Filtre selon l'une des revendications 1 à 6,
dans lequel la première et la deuxième piste de filtrage comportent une connexion en mode commun.

8. Filtre selon l'une des revendications 1 à 7,
dans lequel le ou les premiers convertisseurs et/ou les deuxièmes convertisseurs de la piste de filtrage correspondante comportent une transformation d'impédance, le convertisseur correspondant étant divisé au moins en partie en composantes de convertisseur qui sont branchées électriquement l'une derrière l'autre et qui sont disposées acoustiquement en parallèle l'une de l'autre.
